(19) Europäisches Patentamt
European Patent Office
Office européen des brevets

(11) **EP 1 998 436 A1**

(12) **EUROPEAN PATENT APPLICATION**

(43) Date of publication:
**03.12.2008 Bulletin 2008/49**

(51) Int Cl.:
***H03F 1/32*** *(2006.01)*

(21) Application number: **07010809.7**

(22) Date of filing: **31.05.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(71) Applicant: **Nokia Siemens Networks Oy**
**02610 Espoo (FI)**

(72) Inventors:
• **Bianconi, Mairizio**
**81375 München (DE)**
• **Calabro, Stefano Dr.**
**81375 München (DE)**

(74) Representative: **Schober, Ralf Stefan**
**Nokia Siemens Networks GmbH & Co. KG**
**Patentabteilung**
**Postfach 80 17 60**
**81617 München (DE)**

(54) **Method and device for at least partially compensating nonlinear effects of a system and communication system comprising such device**

(57) A method and a device are provided for at least partially compensating nonlinear effects of a system comprising the steps of (i) evaluating a model of the system, (ii) determining an inverse model of the system by processing an iterative inverting method, said inverting method comprising a convergence check, (iii) substantially compensating the nonlinear effects of the system by said inverse model of the system.

FIG 3

**Description**

The invention relates to a method and device for at least partially compensating nonlinear effects of a system. The invention also relates to a communication system comprising such device.

A common problem in signal processing is the restoration of signals, which have propagated through nonlinear systems, in particular nonlinear channels.

Such nonlinear systems may be, e.g.,

- nonlinear power amplifiers, e.g., used in satellites or in base stations of mobile networks;
- analogue-to-digital converters; and
- nonlinear transmission media, e.g., optical fiber.

Depending on the impact of the nonlinearities, conventional linear signal processing may not suffice to completely recover the information content. If this is the case, the compensation of the nonlinear effects becomes necessary.

In principle, there are two different approaches in order to compensate nonlinear effects of a nonlinear system:

1. A direct compensation, according to which a compensation unit is explicitly determined; and
2. An indirect compensation, according to which a model of the nonlinear system is evaluated first and based on that model an inverse model is determined.

In many practical cases, the structure of an explicit compensator (see approach 1. before) is more complex and thus the estimation of its parameters involves a higher computational burden than to find a model of the nonlinear system itself. For this reason, the second approach has gathered some attention in the literature.

However, the downside of this advantageous modeling-approach (see 2. above) is that it is not trivial to find or determine the inverse model of the nonlinear system. Unfortunately, there is no common closed form of the inverse model available and, in addition, general conditions of the global inversion are unknown.

In order to overcome the burden of the unavailability of a closed form inverse, it is possible to use iterative approximation methods from the field of numerical calculus.

This, however, still leaves the search for a global inversion of the nonlinear system an open issue.

A wide variety of mildly nonlinear systems can be modelled by means of a truncated (discrete-time) Volterra series of the type

$$y[k] = \sum_{l=1}^{L} \sum_{i_1, i_2, \ldots, i_l} h_l(i_1, i_2, \ldots, i_l) \, x[k - i_1] \, x[k - i_2] \cdots x[k - i_l] \quad (1)$$

where the indexes $i_1$, $i_2$, ..., $i_l$ for any $l$ between 1 and $L$ range within a finite subset of the integer ring.

Motivated by the issue of the invertibility, Schetzen (see [1]) developed the theory of the pth-order inverse for truncated Volterra series. The basic idea is to define the pth-order pre-inverse (post-inverse) of a system $H$ as a Volterra system G, such that the cascade $H(G)$ $(G(H))$ differs from the identity system by a Volterra system E, whose kernels of order 0 through p are zero.

Whereas in the original work of Schetzen the pth inverse is constrained to be a pth order Volterra series, Sarti and Pupolin [2] removed any restriction on the higher order kernels, allowing a more efficient computation of G.

According to Sarti and Pupolin [2], a pth order inverse can be always constructed in p recursive steps and is stable whenever the linear component of H is stable and has minimum phase property. Therefore this approach seems to solve the problem of the global invertibility: Under very general conditions it is possible to build a pth order inverse of any order p.

However, from a practical point of view a pth order inverse is useful only if it approximates (at least locally) the true inverse, wherever the latter exists. Obviously, if this is not the case, the pth order inverse cannot compensate nonlinear distortions introduced by a transmission channel leading to a serious convergence issue, i.e. the convergence of the pth order inverse to the true inverse, as p goes to infinity.

Nowak and Van Veen [3] regard the problem of the invertibility under a different perspective. Using tools of functional analysis, they cast the inversion of a (possibly non-truncated) Volterra series into a fixed point problem of the form

$$x \;=\; \mathrm{T}(x), \qquad\qquad\qquad (2)$$

where x is a bi-infinite sequence and T is a mapping of bi-infinite sequences into bi-infinite sequences. To obtain such a formulation, they assume that the linear component of the Volterra series is invertible (i.e. the same condition required for the construction of the pth order inverse).

In analogy with the classical fixed point approach for functions of one or more variables, the authors of [3] derive sufficient conditions for the local convergence of the recursion

$$x_{n+1} \;=\; \mathrm{T}(x_n), \qquad\qquad\qquad (3)$$

starting at a given initial bi-infinite sequence $x_0$.

Specifically, the local convergence of the fixed point method (to the true inverse) requires

(a) *T* to be a contraction mapping on a closed subset *S* of the sequence space; and
(b) the initial sequence $x_0$ to belong to *S*.

Unfortunately, the verification of these conditions requires the evaluation of the norm of bi-infinite sequences, which is generally not feasible. Even the use of so-called "windowed norms", which produces upper bounds on the convergence rate, leads to impractical criteria.

It is noted that, if the original Volterra system has finite memory, the recursion above translates immediately into a viable recursive (local) realization of the inverse system. The number of performed iterations determines the quality of the approximation. Interestingly enough, the resulting implementation for any number p of iterations coincides exactly with that of the pth order inverse.

In summary, the approach of Nowak and Van Veen as described in [3] provides some tools for the theoretical analysis of the local convergence, which however cannot be easily embedded in a real-time system. Thus, this approach does not help in solving the complex issue of the global invertibility.

A different implementation was proposed in [4]. Here, the authors assume that the nonlinear model has finite memory and the output depends, besides the current input sample, also on its previous m values. Thus they reformulate the inversion problem as follows:

$$\mathrm{H}(x[k], x[k-1], \ldots, x[k-m]) - u[k] = 0, \qquad\qquad (4)$$

where u[k] and x[k] denote the input samples at time k to the inverse and to the original nonlinear system, respectively.

Using the previously estimates of

$$x[k-m], \ldots, x[k-1],$$

the authors of [4] solve iteratively Eq. (4) for x[k] by means of the secant method. The algorithm has convergence rate $\phi \cong 1.62$ (whenever it converges) and is therefore much faster than the fixed point method used in [3], which has convergence rate 1.

According to this approach, the iterative algorithm is applied to a function of a single scalar variable x[k] rather than a functional as in [3]. This, however does not help simplifying the convergence analysis. On the contrary, the convergence analysis gets more complex, because the function H is parameterized by $x[k-m]$, ..., $x[k-1]$ and is therefore time-variant.

The authors do not provide any theoretical results, but claim that, if the nonlinearities are "not very hard", the algorithm does not experience any convergence problem, which of course sets some (not well clear) limits to its applicability.

In summary, it is a problem that steps of iterative inverting methods may not converge, hence leading to, e.g.,

a breakdown of the whole compensation.

The object to be solved is to overcome the disadvantages stated before and in particular to provide an inverse model of a system, which inverse model does not lead to a breakdown of the whole compensation.

This problem is solved according to the features of the independent claims. Further embodiments result from the depending claims.

In order to overcome this problem a method for at least partially compensating nonlinear effects of a system is provided comprising the steps:

- Evaluating a model of the system;
- Determining an inverse model of the system by applying an iterative inverting method, said inverting method comprising a convergence check;
- Substantially compensating the nonlinear effects of the system by said inverse model of the system.

An advantage of this approach is the efficient improvement of the iterative inversion of the (nonlinear) system, which circumvents both, checking the local convergence and checking the global invertibility.

Another advantage is that the convergence can be checked in real-time.

In an embodiment, the convergence check comprises the steps of:

- Checking whether the difference in magnitude between the corrections carried out by two consecutive iterations lies within a predetermined range;
- If said difference does not lie within said predetermined range, convergence failure is avoided by setting skipping the last iteration. In particular, the last correction can be set to zero or the result of the considered iteration can be set to its input.

Due to the supervision of the convergence check it is possible to ensure that the output of the system that is influenced by the compensation means (which happens to make use of the inverse model of the system) stays within predetermined limits.

If the inverse model during iteration tends not to converge (e.g., the output of an iteration leaves the predetermined range), the output from a previous iteration (that stayed within the predetermined range) is used as output of the current iteration. This prevents the inverting method from diverging.

The approach provided herein allows to detect the initial tendency to leave the valid range and sets the output of such a step of the iteration to a value that is within the predetermined range, i.e. the previous output of the iterative inverting method.

As an alternative, the iterative inverting method may stop once a value leaving said predetermined range is detected.

It is an embodiment that the nonlinear system is in particular a nonlinear channel or a nonlinear (power) amplifier.

In yet another embodiment, the system or, e.g., nonlinear channel or nonlinear amplifier, may be time variant.

Furthermore, the model of the system may be obtained or estimated by taking into account an input signal to the system and/or an output signal from the system.

In another embodiment nonlinearities of the system are compensated by a distortion compensation unit, in particular the information about the inverse model of the system being used/fed in/to said compensation unit. This compensation unit can be arranged before or after the system.

Hence, the signal is distorted by the (nonlinear) system. The compensation unit pre-distorts or post-distorts the signal to cancel the distortion (in particular due to the nonlinearity) of the system. Hence, the output is substantially "clean", i.e. as if there were (substantially) no nonlinearity of the system (or channel or amplifier) itself.

In a further embodiment, the compensation unit is a digital predistortion unit.

The problem is also solved by a device for at least partially compensating nonlinear effects of a system, the device comprising a processor unit that is arranged such that a method as described is executable on said processor.

In addition, the problem can be solved by a communication system comprising said device.

Embodiments of the invention are shown and illustrated in the following figures:

Fig.1    shows an arrangement as how to compensate nonlinear effects of a time variant system by means of predistortion;

Fig.2    shows an arrangement as how to compensate nonlinear effects of a time variant system by means of postdistortion;

Fig.3    shows a block diagram of an inversion method;

Fig.4    shows an output signal of an power amplifier in the presence of digital predistortion without convergence check;

Fig.5    shows an output signal of an power amplifier in the presence of digital predistortion with a convergence check ensuring stability of this output signal;

Fig.6    shows a flowchart of steps of a method describing how to compensate nonlinear effects of a system.

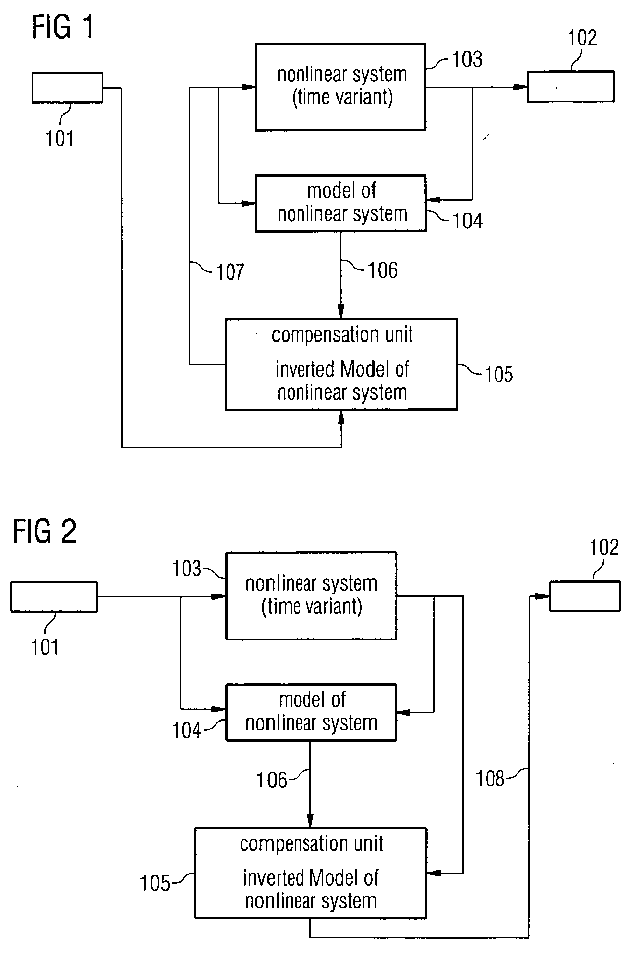

With reference to **Fig.1,** an arrangement is shown as how to compensate nonlinear effects of a time variant system 103.

An input signal 101 is fed to compensation unit 105 that makes use of an inverted model of the nonlinear system 103 to process the input signal 101 into a predistorted signal 107 that is further fed to the nonlinear system 103. Hence, an output signal 102 of the nonlinear system 103 is at least partially freed of the nonlinearities of the system 103. The inverted model of the nonlinear system used in the compensation unit 105 is derived from a model 104 of the nonlinear system 103 by iterative inversion 106. The model 104 of the nonlinear system 103 is preferably built based on an input to the nonlinear system 103 and an output from this nonlinear system 103.

As an alternative, the compensation unit 105 can be located in the output branch after the nonlinear system 103 as shown in **Fig.2.** Reference signs in Fig.2 mainly correspond to those used in Fig.1. In Fig.2, the output signal of the nonlinear system 103 is fed to the compensation unit 105, processed by the inverse model of the nonlinear system 103 and a post-distored signal 108 is forwarded as the output signal 102.

The solution provided herewith checks the convergence of the iterative inverting method and may be combined with any iterative implementation of a nonlinear inverse system, in particular, with the approaches as proposed in [3] and [4].

At any time instant k the sequence of results produced by the iterative process

$$x_0[k], x_1[k], \ldots, x_n[k], \ldots \qquad (5)$$

is considered, which sequence is supposed to converge to the k-th sample of the response of the inverse system, whenever the latter exists.

That sequence is convergent if and only if

$$\lim_{n\to\infty} \left| x_n[k] - x_{n-1}[k] \right| = 0, \qquad (6)$$

i.e. if and only if the sequence of the successive corrections goes to 0 in magnitude.

Motivated by this consideration, the corrections applied by any two successive iterations are compared with one another. If after some iteration the amplitude of the correction increases, the algorithm diverges and hence the next "correction" actually degrades the quality of the current approximation.

Assuming that the nonlinear effects represent only a perturbation with respect to a desired ideal behavior or, in other terms, that they are "mild" (as it is often referred to in the literature), each divergent iteration can be safely bypassed introducing only a local disturbance.

It is practical and advantageous to perform every predefined iteration, but, depending on the result of the convergence check, in case of divergence the input instead of the output of the current iteration has to be fed to the following blocks, i.e. the next step of the iteration.

This would lead to a resulting error at time k being much smaller than the error produced by a iterative procedure without such convergence check.

When the nonlinear system is provided with memory, the advantages of the current approach are even more significant. Here, a wrong estimate of x[k] would also affect the following iterations. Therefore, a coarse error due to local divergence, which typically looks like a spike, can trigger a chain of subsequent errors and could cause a break down of the inversion method and lead to an instability of the system.

On the contrary, avoiding the divergence would bind the output of all iterations to an admissible range and hence assure that the nonlinear model is always fed with reasonable values, i.e. values that avoid an overall instability of the whole system.

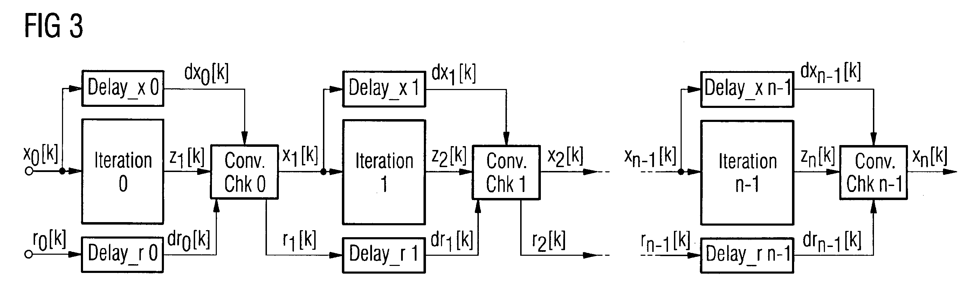

**Fig. 3** represents an inversion method by means of an exemplary block diagram. Each block denoted by

## "Iteration i" (for i = 0, 1, …, n-1)

performs a step of an iterative inversion algorithm. Such iterative inversion algorithm could be, e.g. , the fixed point algorithm described in [3] or the secant method described in [4].

The input $x_i[k]$ is the current approximation of the response of the inverse system at time k. The output $z_{i+1}[k]$ is the next approximation computed by the block.

The block "Conv. Chk i" implements the convergence check according to the following equations

$$r_{i+1}[k] = \min\left\{ dr_i[k], \left| z_{i+1}[k] - dx_i[k] \right|^2 \right\}$$

$$(7),$$

$$x_{i+1}[k] = \begin{cases} z_{i+1}[k] , & \text{if } r_{i+1}[k] < dr_i[k] \\ dx_i[k] , & \text{if } r_{i+1}[k] \geq dr_i[k] \end{cases}$$

where $r_{i+1}[k]$ is the norm of the last valid correction and $x_{i+1}[k]$ is considered to be the best approximation up to now of the response at time k.

As an alternative solution, the remaining iterations may be skipped after a failed convergence check (e.g., by setting the norm $r_{i+1}[k]$ to 0).

The (optional) delay lines

## "Delay x i" and "Delay r i" (for i = 0, 1, …, n-1)

compensate the latency of "Iteration i" and provide delayed versions $dx_i[k]$ and $dr_i[k]$ of $x_i[k]$ and $r_i[k]$, respectively.

To initialize the inversion method, it may be set (see also, e.g., [2], [3], [4]):

$$x_0[k] = u[k] \qquad (8),$$

where u[k] is the sample at time k of the sequence that has to be inverted.

The norm $r_0[k]$ defines an upper limit for the magnitude of the correction applied at any iteration. It can be set to a constant predefined value or, preferably, to

$$r_0[k] = \alpha \cdot \left| x_0[k] \right|^2 \qquad (9),$$

where $\alpha$ is a real positive constant. The latter initialization is particularly sensible for quasi-linear systems, where the nonlinear distortion is proportional to the instantaneous power of the input signal.

In many practical applications, the nonlinear system, which constitutes the transmission channel at hand, is not (completely) known a priori and must be therefore characterized during operation. If the system is time variant, e.g. due to changes in the environmental conditions or in the characteristics of the stimulus, an adaptive estimate is required.

Even when the nonlinear system is invertible over some operational range of interest, due to estimation/adaptation errors, the model may not admit an inverse over the full range of operation, or the iterative inversion might fail to converge. In these situations an uncontrolled algorithm would produce large errors or even break down.

To avoid this risk, it is necessary to support the inverting method by supervising the model. If the convergence region of the model does not cover the whole operational range, the model can be either modified (to extend its convergence region) or the input can be forced to a valid (preferably predetermined) range (to avoid convergence failure).

According to the supervision of the convergence described herein, the estimated model does no longer need to be monitored, thus saving a great amount of computational effort and avoiding potential sources of errors.

Another advantage of the solution provided is that a hardware implementation would require only a few delay lines, a comparator and two (in case of complex signals) multipliers for every iteration.

An additional benefit is the general applicability to a broad spectrum of nonlinear systems and iterative solutions: As the proposed solution does not rely on the characteristic of specific nonlinear systems or nonlinear models, and can be combined with any iterative algorithm, it is very flexible and could be applied to different kinds of applications, e.g., nonlinear channels or nonlinear amplifiers.

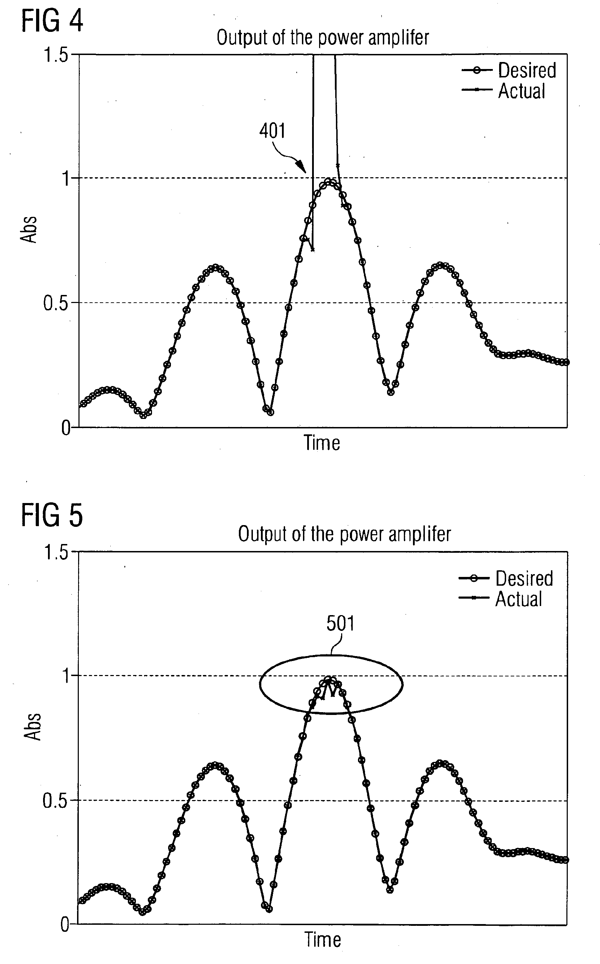

In order to show the effectiveness of the provided solution, the pre-inversion of a nonlinear microwave power amplifier has been simulated. The amplifier was modeled as a truncated Volterra series on the basis of some experimental data. The pre-inverter performed three iterations of the secant method, as described in [4]. In the absence of the convergence check, the simulation showed a few isolated power peaks at the output of the amplifier. In a real system these peaks would have damaged the electronic components. **Fig.4** shows the amplitude of the output signal 401 in the proximity of one such peak.

However, applying the proposed concept of the convergence check would lead to a different result as shown in **Fig.5**: All power peaks in an area 501 vanished and left place to small fluctuations of the output around the desired value. Thus, the quality of the amplified signal is drastically improved both in terms of modulation accuracy and consequently spectral characteristics.

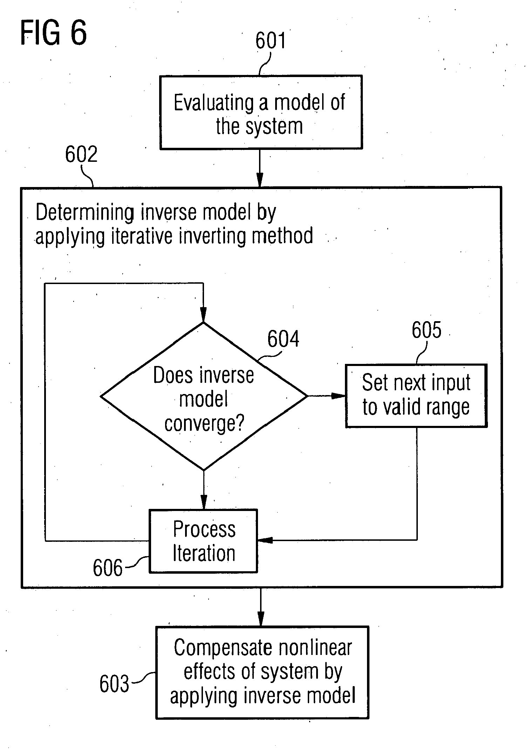

**Fig.6** comprises a flowchart with several steps showing how to compensate nonlinear effects of a system as described.

In a step 601 a system is modeled or evaluated. For this model, in a step 602 an inverse model is computed by applying an iterative inverting method. Part of this iterative inverting method is a convergence check: In a block 604 it is checked whether the inverse model converges. This can be done, e.g., according to equation (7) as described supra. If the iteration leads in a subsequent step to a reduced error (i.e. the iteration converges), a step 606 is run, proceeding with the iteration (and a subsequent convergence check). If the iteration diverges, i.e. the output shows a greater norm than the output of the previous iteration, a step 605 avoids any divergence of the inverting method by setting the current output of the iteration to a valid range.

As an alternative, step 605 could skip remaining iterations, e.g., by setting the norm $r_{i+1}[k]$ to zero thus leading to a defined result of the iterative inverting method and avoiding any divergence.

After the inverse model is determined in step 602, it is used in a subsequent step 603 in order to compensate nonlinear effects of the system (that may be time variant). Such compensation could be performed, e.g., as pre-distortion or post-distortion. The compensation could be done in a digital compensation unit.

The steps described may run on a processor or computer and may be implemented in hardware or as firmware or software which may be arranged or stored to be operable on such devices.

**List of Literature:**

[1] M. Schetzen, "Theory of the pth-Order Inverses of Nonlinear Systems", IEEE Trans. on Circuits and Systems, vol. CAS-23, no. 5, May 1976, pp. 285-291.

[2] A. Sarti, and S. Pupolin, "Recursive Techniques for the Synthesis of a pth-Order Inverse of a Volterra System", European Trans. on Telecomm., vol. 3, no. 4, Jul.-Aug. 1992, pp. 315-322.

[3] R. D. Nowak, and B. D. Van Veen, "Volterra Filter Equalization: A Fixed Point Approach", IEEE Trans. on Signal Processing, vol. 45, no. 2, Feb. 1997, pp. 377-388.

[4] E. Aschbacher, H. Arthaber, and M. Rupp, "A Fast Algorithm for Digital Pre-Distortion of Nonlinear Power Amplifiers", EURASIP, 13th European Sig. Proc. Conf. (EUSIPCO), Antalya, 2005

**Claims**

**1.** A method for at least partially compensating nonlinear effects of a system, comprising the steps:

- Evaluating (601) a model of the system;
- Determining (602) an inverse model of the system by applying an iterative inverting method, said inverting method comprising a convergence check;
- Substantially compensating (603) the nonlinear effects of the system by said inverse model of the system.

2. The method according to claim 1, wherein the convergence check comprises the steps of:

- Checking (604) whether the difference in magnitude between the corrections carried out by two consecutive iterations lies within a predetermined range;
- If said difference does not lie within said predetermined range, convergence failure is avoided by setting the result (605) of the considered iteration to its input.

3. The method according to any of the previous claims, wherein the system is a nonlinear channel.

4. The method according to any of claims 1 to 2, wherein the system is a nonlinear power amplifier.

5. The method according to any of the previous claims, wherein the system is time variant.

6. The method according to any of the previous claims, wherein the model of the system is estimated by using an input signal to the system and an output signal from the system.

7. The method according to any of the previous claims, wherein nonlinearities are compensated by a distortion compensation unit, wherein the inverse model of the system is fed to said distortion compensation unit.

8. The method according to any of the previous claims, wherein the distortion compensation unit is arranged before or after the system.

9. The method according to any of the previous claims, wherein the distortion compensation unit is a digital predistortion unit.

10. A device for at least partially compensating nonlinear effects of a system, the device comprising a processor unit that is arranged such that the method according of any of the preceding claims is executable on said processor.

11. Communication system comprising the device according to claim 10.

# FIG 1

# FIG 2

FIG 3

## FIG 4

### Output of the power amplifer

## FIG 5

### Output of the power amplifer

# FIG 6

601

Evaluating a model of
the system

602

Determining inverse model by
applying iterative inverting method

604

Does inverse
model
converge?

605

Set next input
to valid range

606

Process
Iteration

603

Compensate nonlinear
effects of system by
applying inverse model

**European Patent Office**

## EUROPEAN SEARCH REPORT

Application Number

EP 07 01 0809

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 01/05026 A (DATUM TELEGRAPHIC INC [CA]) 18 January 2001 (2001-01-18) | 1,3-11 | INV.<br>H03F1/32 |
| Y | * page 53, line 31, paragraph 5.4.2 - line 32 * | 2 | |
| Y | MING YU AND E. KUFFEL: "A New Algorithm for Evaluating the Fields Associated with HVDC Power Transmission Lines in the Presence of Corona and Strong Wind" IEEE TRANSACTIONS ON MAGNETICS, [Online] vol. 29, no. 2, March 1993 (1993-03), pages 1985-1988, XP002467059 Retrieved from the Internet: URL:http://ieexplore.ieee.org/iel1/20/6418/00250798.pdf?arnumber=250798> [retrieved on 2008-01-30] * page 1987, left-hand column, line 17 - line 21 * | 2 | |
| D,A | ASCHBACHER, E; ARTHABER,H;RUPP,M: "A Fast Algorithm for Digital Pre-Distortion of NonLinear Power Amplifiers" 13TH EUROPEAN SIGNAL PROCESSING CONFERENCE (EUSIPCO), [Online] 4 September 2005 (2005-09-04), - 8 September 2005 (2005-09-08) XP002466992 Antalya, Turkey Retrieved from the Internet: URL:http://www.ee.bilkent.edu.tr/~signal/defevent/papers/cr1197.pdf> [retrieved on 2007-01-25] * the whole document * | 1,3-8 | TECHNICAL FIELDS SEARCHED (IPC)<br><br>H03F |

The present search report has been drawn up for all claims

| Place of search | Date of completion of the search | Examiner |
|---|---|---|
| The Hague | 31 January 2008 | Van den Doel, Jules |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 07 01 0809

This annex lists the patent family members relating to the patent documents cited in the above-mentioned European search report.
The members are as contained in the European Patent Office EDP file on
The European Patent Office is in no way liable for these particulars which are merely given for the purpose of information.

31-01-2008

| Patent document cited in search report | | Publication date | Patent family member(s) | | Publication date |
|---|---|---|---|---|---|
| WO 0105026 | A | 18-01-2001 | AT | 276603 T | 15-10-2004 |
| | | | AU | 6009400 A | 30-01-2001 |
| | | | DE | 60013852 D1 | 21-10-2004 |
| | | | EP | 1203445 A1 | 08-05-2002 |
| | | | EP | 1280273 A2 | 29-01-2003 |
| | | | US | 6798843 B1 | 28-09-2004 |

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **M. SCHETZEN.** Theory of the pth-Order Inverses of Nonlinear Systems. *IEEE Trans. on Circuits and Systems,* May 1976, vol. CAS-23 (5), 285-291
- **A. SARTI ; S. PUPOLIN.** Recursive Techniques for the Synthesis of a pth-Order Inverse of a Volterra System. *European Trans. on Telecomm.,* July 1992, vol. 3 (4), 315-322

- **R. D. NOWAK ; B. D. VAN VEEN.** Volterra Filter Equalization: A Fixed Point Approach. *IEEE Trans. on Signal Processing,* February 1997, vol. 45 (2), 377-388
- **E. ASCHBACHER ; H. ARTHABER ; M. RUPP.** A Fast Algorithm for Digital Pre-Distortion of Nonlinear Power Amplifiers. *EURASIP, 13th European Sig. Proc. Conf. (EUSIPCO,* 2005